# EUROPEAN PATENT APPLICATION

(11) **EP 2 264 780 A2**
(43) Date of publication of application: **22.12.2010**
(21) Application number: 10165595.9
(22) Date of filing: 10.06.2010
(51) Int. Cl.: H01L 31/0352, H01L 31/18

(54) **Nano-structured solar cell**

(30) Priority: 15.06.2009 US 484608
(71) Applicant: Honeywell International Inc., Morristown, NJ 07962 (US)
(72) Inventor: Zook, David J, Golden Valley, MN 55422 (US); Marcus, Matthew S., Morristown, NJ 079962-2245 (US); Liu, Yue, Plymouth, MN 55447 (US)
(74) Representative: Buckley, Guy Julian

(57) **Abstract**

A solar cell (100) includes a first electrode (110) and an array of ordered electron conductive nanostructure films (115) electrically coupled to and supported by the first electrode (110). A plurality of quantum dot absorbers (120) are attached to the electrically conductive nanostructure films (115). A hole conducting material (125) is diffused between the electron conductive nanostructure films (115), and a second electrode (130) is electrically coupled to the hole conducting material (125).

## Description

### Background

Transparent porous films, such as Ti02 nanoparticle (NP) films have played an important role as electron conductors in devices like dye sensitized solar calls. However, electrons injected from the light absorbing sensitizer are subject to losses from the many particle boundaries along random, tortuous, transport paths. Other solar cell devices utilizing nanostructures also suffer from inefficiencies in the electron transport paths. Recombination losses at the absorber - electron conductor and hole conductor interfaces - will limit the overall utility of prior nano-enabled solar cells.

### Brief Description of the Drawings

FIG. 1 is a block cross section diagram of a nano-structure solar cell according to an example embodiment.
FIG. 2 is a flowchart illustration of a method of making a nano-structure solar cell according to an example embodiment.

### Detailed Description

In the following description, reference is made to the accompanying drawings that form a part hereof, and in which is shown by way of illustration specific embodiments which may be practiced. These embodiments are described in sufficient detail to enable those skilled in the art to practice the invention, and it is to be understood that other embodiments may be utilized and that structural, logical and electrical changes may be made without departing from the scope of the present invention. The following description of example embodiments is, therefore, not to be taken in a limited sense, and the scope of the present invention is defined by the appended claims.

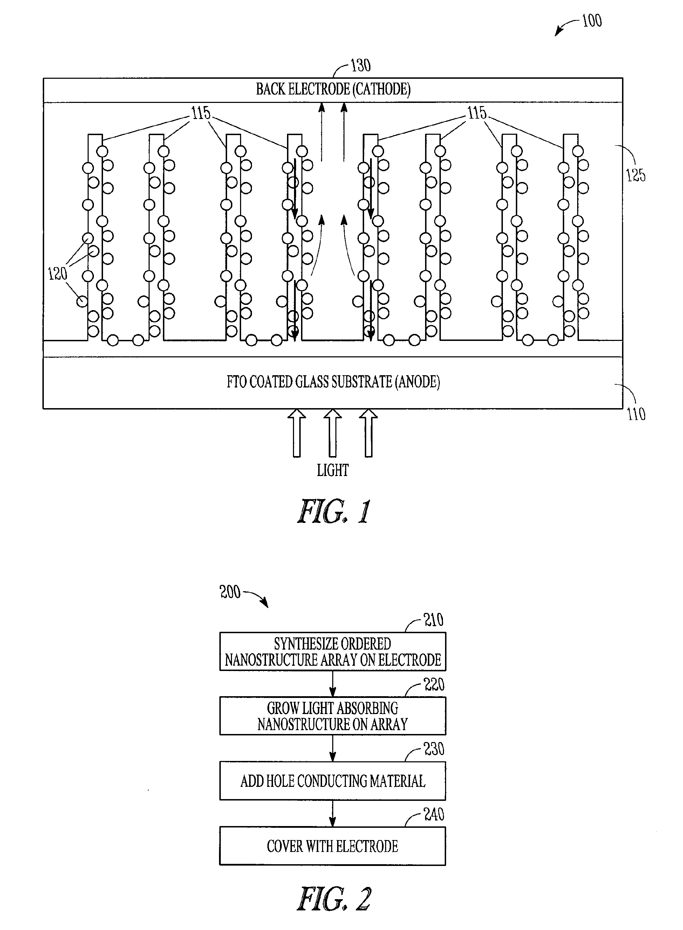

FIG. 1 is a cross sectional block representation of a nano-structured solar cell 100. In one embodiment, the solar cell 100 has a first electrode 110. An array of electrically conductive nanostructure films 115 are electrically coupled to and supported by the first electrode 110. In one embodiment, the nanostructure films 115 comprise nanowires, nanotubes, or a combination of both. The films may be ordered such as by rows and columns, or somewhat random with an average spacing in various embodiments. A plurality of nanocrystalline absorbers 120 (only one shown with reference number 120) are attached to the electron conductive nanostructure films 115. Examples of nanocrystalline light absorbers include, but are not limited to, semiconductor quantum dots, thin continuous semiconductor films, and thin discontinuous semiconductor films. A hole conducting material 125 is disposed or diffused between the electron conducting nanostructure films 115. The nanostructure films 115 provide a highly textured surface in one embodiment, such that the surface are of the films is greatly increased. The hole conducting material 125 thus infiltrates between and into the textured surface of the films. A second electrode 130 is electrically coupled to the hole conducting material 125.

In one embodiment, the first electrode 110 may be transparent, and comprises an anode and the second electrode 130 comprises a cathode. The first electrode 110 may be formed utilizing a fluorinated tin oxide or indium tin oxide coated flexible substrate. In further embodiments, the substrate may be formed of glass with a conductive top layer that is electrically coupled to the nanostructured film 115. In one embodiment, the second electrode is formed of platinum with some titanium.

The second electrode may be reflective in one embodiment, such that light entering the through the first electrode 110 may be absorbed by the nanocrystalline absorbers 120 to create electron hole pairs, and light not so absorbed, is reflected back through the film 115, some of which is also absorbed by the nanocrystalline absorbers 120 to create further electron hole pairs.

In one embodiment, the film 115 comprises an ordered array of nanowires and/or nanotubes that have a partially uniform nano-pore structure that allows better penetration for the hole conducting medium and growth path or attachment path for the nanocrystalline light absorbing material. The nanowires or nanotubes may be formed on the first electrode 110 in a self assembled manner utilizing a solution growth or anodization process. The film 115 may be formed using visibly transparent large band-gap semiconductors, such as TiO₂ or ZnO in various embodiments. The film 115 provides a high surface area porous electron conducting surface. In one embodiment, the film has a thickness of approximately 0.5 to 10 µm.

The nanocrystalline light absorber may then be grown or formed directly on the film 115 via a chemical bath deposition (CBD), selective ionic layer adsorption and reaction (SILAR), chemical vapor deposition process, or by self assembly. By forming or growing the light absorbers directly on the electron conducting film structures, the nanocrystalline light absorbers 120 become attached to the surface of the electron conducting structures and form efficient electron conduction paths, allowing transport without significant recombination. Limiting electronic recombination enhances the device performance and utility.

In one embodiment, the hole conducting material 125 comprises a porous material having open pores, and a hole conductive fluid. The hole conductive fluid comprises at least one of an aqueous electrolyte, ionic liquid, gel electrolytes, and polymers in various embodiments. The porous material is part of the array of ordered electrically conductive nanostructure films and may provide support for at least one of nanowires and nanotubes. The hole conducting material 125 and second electrode 130 provide a hole conducting path.

Such a nanowire or nanotube film 115 provides ordered nanostructures that serve as electron conductors. In some embodiments, the nanostructures have a more continuous and straight crystalline structure, providing a straightforward path for electron transport. Such nanostructures may also provide pore structures that are inverted with respect to flat films. Such pore structures may be easier for hole conducting material to infiltrate, thus providing a similarly efficient transport path for holes and application of hole conducting material.

A method of making the nano-structured solar cell 100 is illustrated generally at 200 in FIG. 2. At 210, an ordered conductive nanostructure array is synthesized on a transparent conducting electrode. At 220, light absorbing nanocrystalline structures, such as quantum dots, are grown onto the ordered conductive nanostructure array. Step 220 may also include attaching pre-grown light absorbing material to the nanostructured electron conductors synthesized at step 210. Step 220 may also include deposition of additional thin layers with the function of protecting the light absorber or electron conductor. Step 220 may also include the deposition of additional thin layers with the function of increasing the device performance by limiting recombination or increasing the ability for materials to bond with the electron conductor synthesized at step 210. A hole conducting material is added at 230 such that the hole conducting material infiltrates the nanostructure array. At 240, a reflective conducting electrode is provided that is electrically coupled to the hole conducting material.

In various embodiments, the nanostructure array may be synthesized by use of a chemical vapor deposition or hydrothermal process and may be formed of zinc oxide or titanium dioxide. The light absorbing nanostructures may be grown directly onto the ordered or somewhat random electron conducting nanostructure arrays using a solution based process, such as a chemical bath deposition or successive ionic layer adsorption reaction (SILAR).

In one embodiment, the absorbing material composition and geometry may be adjusted to control alignment of energy bands to ensure efficient electron injection. In general, confining electronic carriers to nanometer sized dimensions in semiconductors alters the material's optical and electronic properties. For example, the band-gap, valence band and conduction band energies can be tuned by changing the material's dimension. Tuning these energies can increase the performance and utility of a solar cell device. A material's dimension and geometry can be changed by altering one of the many growth parameters during the light absorber's synthesis. Examples of parameters that control the dimension and geometry of the nanocrystalline light absorber include growth time, pH, coordinating and non-coordinating solvent, relative concentration of the growth materials, and growth temperature. Different growth mechanisms for the nanocrystalline light absorbers - such as solution, vapor, and plasma - may have different mechanisms for changing the material's dimension and geometry.

In one embodiment, the light absorbing material comprises at least one of lead and cadmium chalcogenide, and ZnS. In another embodiment, the light absorbing material comprises a non-toxic substance. Examples of non-toxic nanocrystalline absorbers include silicon and indium, gallium, phosphorus compisitions. These materials may be used to effectively span the visible light region. Adding layers of ZnS to the exposed surface of the nanostructures may help prevent trap states, increasing solar cell device efficiency by reducing recombination.

The Abstract is provided to comply with 37 C.F.R. § 1.72(b) to allow the reader to quickly ascertain the nature and gist of the technical disclosure. The Abstract is submitted with the understanding that it will not be used to interpret or limit the scope or meaning of the claims.

## Claims

1. A solar cell (100) comprising:
a first electrode (110);
an array of electron conducting nanostructure films (115) electrically coupled to and supported by the first electrode (110);
a plurality of nanocrystalline light absorbers (120) attached to the electron conductive nanostructure films (115);
a hole conducting material (125) disposed between the electron conducting nanostructure films (115); and
a second electrode (130) electrically coupled to the hole conducting material.

2. The solar cell (100) of claim 1 wherein the electron conducting nanostructure films (115) comprise nanowires.

3. The solar cell (100) of claim 1 wherein the electron conducting nanostructure films (115) comprise nanotubes.

4. The solar cell (100) of claim 1 wherein the first electrode (110) comprises a transparent anode and the second electrode (130) comprises a cathode with an optically reflective surface.

5. The solar cell (100) of claim 1 wherein the first electrode (110) comprises a fluorinated tin oxide coated flexible substrate.

6. The solar cell (100) of claim 1 wherein the hole conductor (125) comprises a porous material having open pores, and a hole conductive fluid comprising at least one of an aqueous electrolyte, ionic liquid, gel electrolytes, and polymers.

7. The solar cell (100) of claim 6 wherein the porous material is part of the array of electron conducting materials (125) and provides support for at least one of nanowires and nanotubes.

8. A method (200) comprising:
synthesizing (210) an ordered electron conductive nanostructure array (115) on a transparent conducting electrode (110);
growing (220) light absorbing nanostructures (120) onto the ordered conductive nanostructure array (115);
adding (230) a hole conducting material (125) such that the hole conducting material infiltrates the nanostructure array (115); and
providing (240) a reflective conducting electrode that is electrically coupled to the hole conducting material.

9. The method of claim 8 wherein the nanostructure array (115) comprises at least one of nanowires and nanotubes.

10. The method of claim 8 wherein the light absorbing nanostructures (120) are grown directly onto the electron conductive nanostructure array (115) using a solution based process and wherein the absorbing material composition and geometry are adjusted to control alignment of energy bands to ensure efficient electron injection.
